(19) Europäisches Patentamt / European Patent Office / Office européen des brevets

(11) **EP 2 834 873 B1**

(12) **FASCICULE DE BREVET EUROPEEN**

(45) Date de publication et mention de la délivrance du brevet:
**14.09.2016 Bulletin 2016/37**

(51) Int Cl.:
**H01M 10/44** *(2006.01)*  **H01M 10/48** *(2006.01)*
**H01M 2/36** *(2006.01)*  **H01M 10/06** *(2006.01)*

(21) Numéro de dépôt: **13713444.1**

(22) Date de dépôt: **02.04.2013**

(86) Numéro de dépôt international:
**PCT/EP2013/056873**

(87) Numéro de publication internationale:
**WO 2013/149991 (10.10.2013 Gazette 2013/41)**

(54) **PROCÉDE DE CHARGE D'UN ACCUMULATEUR AU PLOMB PRENANT EN COMPTE SON OXYDATION, PROCÉDÉ DE GÉNERATION D'UN ABAQUE POUR LE PROCÉDÉ DE CHARGE, DISPOSITIF ASSOCIÉ AU PROCÉDÉ DE CHARGE, SUPPORT D'ENREGISTREMENT ASSOCIÉ AU PROCÉDÉ DE CHARGE**

VERFAHREN ZUM LADEN EINER BLEISÄUREBATTERIE UNTER BERÜCKSICHTIGUNG DER OXIDIERUNG, VERFAHREN ZUR ERZEUGUNG EINER GRAFISCHEN DARSTELLUNG DES LADEVERFAHRENS, VORRICHTUNG IM ZUSAMMENHANG MIT DEM LADEVERFAHREN SOWIE AUFZEICHNUNGSMEDIUM IM ZUSAMMENHANG MIT DEM LADEVERFAHREN

METHOD FOR CHARGING A LEAD-ACID BATTERY WHILE TAKING THE OXIDATION THEREOF INTO CONSIDERATION, METHOD FOR GENERATING A GRAPH FOR THE CHARGING METHOD, DEVICE ASSOCIATED WITH THE CHARGING METHOD, AND RECORDING MEDIUM ASSOCIATED WITH THE CHARGING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.04.2012 FR 1253064**

(43) Date de publication de la demande:
**11.02.2015 Bulletin 2015/07**

(73) Titulaire: **Commissariat à l'Énergie Atomique et aux Énergies Alternatives 75015 Paris (FR)**

(72) Inventeurs:
- **CHRISTIN, Rémy**
  **F-74350 Cruseilles (FR)**
- **GENIES, Sylvie**
  **F-38120 Saint Egreve (FR)**
- **KLEIN, Jean-Marie**
  **F-73420 Viviers Du Lac (FR)**

(74) Mandataire: **Novaimo Bâtiment Europa 2 310 avenue Marie Curie Archamps Technopole 74166 Saint-Julien-en-Genevois Cedex (FR)**

(56) Documents cités:
**AU-B2- 505 599**

- **J.E. MANDERS: "Quality-control techniques for dry charging lead/acid batteries", JOURNAL OF POWER SOURCES, vol. 19, no. 2-3, 1 février 1987 (1987-02-01), pages 189-199, XP055049377, ISSN: 0378-7753, DOI: 10.1016/0378-7753(87)80029-0**
- **C&d Technologies ET AL: "RS-1476. Standby Battery. Vented Cell. Installation and Operating Instructions. (extracts from)", , 1 janvier 2010 (2010-01-01), page 1, 21-24, XP055049456, Blue Bell, PA, USA Extrait de l'Internet: URL:http://www.cdtechno.com/pdf/ref/rs_147 6_0610.pdf [extrait le 2013-01-14]**

**(Cont. page suivante)**

- V. ILIEV ET AL: "Self-Discharge and Passivation Phenomena in Lead-Acid Batteries during Storage", JOURNAL OF THE ELECTROCHEMICAL SOCIETY, vol. 129, no. 3, 1 mars 1982 (1982-03-01), pages 458-464, XP055049381, ISSN: 0013-4651, DOI: 10.1149/1.2123880

## Description

### Domaine technique de l'invention

L'invention concerne le domaine des accumulateurs au plomb.

L'invention a pour objet plus particulièrement un procédé permettant de recharger un accumulateur au plomb, notamment après une période de stockage sans électrolyte ayant engendré une oxydation du plomb présent dans l'accumulateur.

### État de la technique

À l'heure actuelle, les fabricants d'accumulateurs et leurs prestataires limitent la durée de stockage d'accumulateur chargé sec (en indiquant également des fourchettes de températures voire d'hygrométrie à respecter) afin de garantir une capacité pleine et entière pour une durée de charge initiale standardisée. Par « chargé sec », on entend dans la présente description un accumulateur ayant été rempli par son électrolyte, puis chargé, avant de subir un assèchement de sorte à retirer tout son électrolyte avant stockage.

Plus généralement, pour pallier au cas où, malgré le respect des consignes de stockage, l'accumulateur présenterait une oxydation anormale de sa matière active, la procédure de charge initiale préconisée, après ajout de l'électrolyte, est très largement surdimensionnée en durée de charge (48h avec un régime minimum de 5A pour 100 Ah de capacité nominale). En outre, en cas de forte oxydation de la matière active négative, les procédures de remplissage en électrolyte (standardisées elles aussi) entraînent des délais supplémentaires avant la mise en service, voire la considération de ces accumulateurs comme défaillants. En effet, dans ces procédures la température de l'électrolyte ne doit pas excéder 30°C, ce qui impose un remplissage par ajouts successifs d'électrolyte entrecoupé de pauses importantes pour que celui-ci se refroidisse.

Dès lors, les phases de charge d'une batterie au plomb qui aurait été oxydée peuvent être longues. Il résulte donc une problématique d'optimisation du temps de charge après stockage, notamment chargé sec de l'accumulateur.

Les documents AU505599 et « Quality-Control techniques for dry charging lead/acid batteries » de J.E. MANDERS publié dans Journal of Power Sources vo. 19 no 2-3 du 1 février 1987 pages 189 à 199 s'intéressent au fonctionnement des batteries ainsi qu'à leurs utilisations.

### Objet de l'invention

Le but de la présente invention est de proposer une solution permettant d'optimiser l'accumulateur lors de sa première charge, notamment pour un accumulateur stocké chargé sec.

Ce but peut notamment être atteint par les revendications annexées et plus particulièrement par un procédé de charge d'un accumulateur au plomb comprenant une phase d'initialisation au cours de laquelle une valeur représentative d'une quantité d'oxyde de plomb, valeur correspondant à une quantité d'oxyde de plomb formée à la surface de la matière active négative de l'accumulateur au plomb chargé sec lors de son stockage, est déterminée, et une phase de charge dont la durée est déterminée en fonction de la valeur représentative de quantité d'oxyde de plomb, cette détermination étant réalisée à partir d'un abaque donnant la quantité d'oxyde de plomb en fonction d'une élévation de la température, ou d'une valeur représentative de la densité.

L'invention est aussi relative à un procédé de génération d'un abaque destiné à être utilisé dans le procédé de charge, ledit procédé de génération de l'abaque comporte la génération de l'abaque à partir d'au moins une mesure d'un paramètre physique d'un accumulateur au plomb au moins partiellement oxydé, et la corrélation de cette mesure à une valeur représentative d'une quantité d'oxyde de plomb de la matière active négative de l'accumulateur.

L'invention est aussi relative à un dispositif comprenant un accumulateur et une unité de calcul configurée pour réaliser le procédé de charge, notamment ce dispositif peut comprendre un capteur de température, notamment de type thermocouple, configuré pour mesurer l'élévation de la température au cours de la phase d'initialisation.

L'invention est aussi relative à un support d'enregistrement de données lisible par un calculateur, sur lequel est enregistré un programme informatique comprenant des moyens de codes de programme informatique de mise en oeuvre des phases et/ou étapes du procédé de charge.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 illustre un procédé de charge d'un accumulateur,
- la figure 2 représente un graphique donnant en fonction du temps l'évolution de la tension aux bornes d'un accumulateur en phase de charge, et l'évolution de la dérivée de la tension,
- La figure 3 représente un procédé de génération d'un abaque destiné à être utilisé pour déterminer le temps de charge d'un accumulateur au plomb,
- La figure 4 illustre une représentation du taux d'oxyde de plomb présent dans un accumulateur avant imbibition par son électrolyte en fonction de l'élévation de la température en °C au cours d'une phase d'imbibition,
- La figure 5 illustre une représentation du taux d'oxyde de plomb présent dans un accumulateur avant imbibition par son électrolyte en fonction de la densité de son électrolyte relevée après 24 heures d'imbibition et un retour à la température ambiante, de 25°C dans l'exemple, suite à l'exothermicité de la réaction d'imbibition,
- La figure 6 illustre un dispositif destiné à être utilisé avec le procédé de charge.

**Description de modes préférentiels de l'invention**

La solution décrite ci-après diffère de l'art antérieur notamment en ce que l'on ne cherche pas à réaliser une charge surdimensionnée pour éviter les problèmes liés à l'oxydation de l'accumulateur, mais plutôt à dimensionner la charge en fonction de l'oxydation de l'accumulateur.

En fait, la matière active négative d'un accumulateur au plomb normalement manufacturé est quasi exclusivement formée de plomb. Avant que la matière négative soit mise en contact avec son électrolyte pour que l'accumulateur soit fonctionnel, c'est-à-dire lors d'un stockage par exemple chargé sec de l'accumulateur, le plomb est en contact direct avec l'air. Ce contact avec l'air et l'humidité ambiante amène naturellement ce plomb à s'oxyder pour former de l'oxyde de plomb PbO, phénomène qui s'accumule petit à petit au cours du temps.

Dès lors, plus la période de stockage sera longue, plus l'oxyde de plomb s'accumulera, jusqu'à une certaine limite fonction de la porosité du matériau (oxydation de surface).

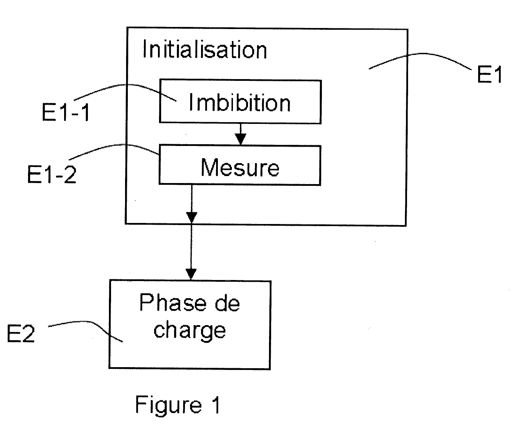

Ainsi, pour améliorer le temps de mise en service d'un accumulateur au plomb, il a été développé un procédé de charge d'un accumulateur au plomb (figure 1) comprenant une phase d'initialisation (E1) au cours de laquelle une valeur représentative d'une quantité d'oxyde de plomb dans l'accumulateur est déterminée. Le procédé comporte en outre une phase de charge (E2) dont la durée $t_{ch}$ est déterminée en fonction de la valeur représentative de quantité d'oxyde de plomb.

En fait, dans la présente description, la valeur représentative de la quantité d'oxyde de plomb dans l'accumulateur est avantageusement la valeur représentative de la quantité d'oxyde de plomb de la matière active négative de l'accumulateur, se présentant notamment en surface de ladite matière active négative. La matière active négative forme une électrode de l'accumulateur. On comprend de ce qui a été dit précédemment que cet oxyde de plomb est formé à la surface de la matière active négative d'un accumulateur au plomb chargé sec lors de son stockage.

Plus particulièrement, l'oxyde de plomb formé à la surface de la matière active négative d'un accumulateur au plomb chargé sec lors de son stockage est distinct de l'oxyde de plomb $PbO_2$ constituant la matière active positive de cet accumulateur. En fait, $PbO_2$ est la forme la plus oxydée du plomb, et est donc inerte chimiquement vis-à-vis de l'oxydation de l'air pendant le stockage (ce qui n'est pas le cas du plomb Pb qui s'oxyde en PbO durant le stockage). $PbO_2$ est également inerte chimiquement vis-à-vis de l'acide sulfurique, il ne provoque donc aucune réaction chimique avec celui-ci pouvant engendrer une élévation de température ($PbO_2$ n'est électrochimiquement actif que lors de l'usage en charge/décharge de l'accumulateur, l'acide sulfurique jouant alors un rôle dans les processus associés).

En fait, avant réalisation du procédé de charge, l'accumulateur étant stocké chargé sec, la quantité d'oxyde de plomb que l'on cherche à déterminer est celle présente juste avant que l'on réalise une imbibition de l'accumulateur par son électrolyte. Dès lors, la phase d'initialisation peut commencer en prévoyant un accumulateur sans électrolyte, notamment chargé sec, puis en réalisant l'imbibition de ce dernier par son électrolyte.

L'étude comportementale des réactions chimiques lors de l'ajout de l'électrolyte (imbibition) et d'une phase de charge de l'accumulateur a montré qu'elle est le siège de deux réactions chimiques consécutives.

La première réaction est définie par l'équation suivante :

$$PbO + H_2SO_4 \rightarrow PbSO_4 + H_2O \qquad (1)$$

L'équation (1), commence dès l'ajout de l'électrolyte $H_2SO_4$ dans l'accumulateur. Cet ajout correspond à une imbibition de l'accumulateur par l'électrolyte de sorte que l'acide sulfurique de l'électrolyte va réagir totalement avec l'oxyde de plomb PbO pour former du sulfate de plomb $PbSO_4$.

La deuxième réaction prend place au cours de la charge, notamment réalisée à courant constant, et est définie par l'équation suivante :

$$PbSO_4 + 2H^+ + 2\,é \rightarrow Pb + H_2SO_4 \qquad (2)$$

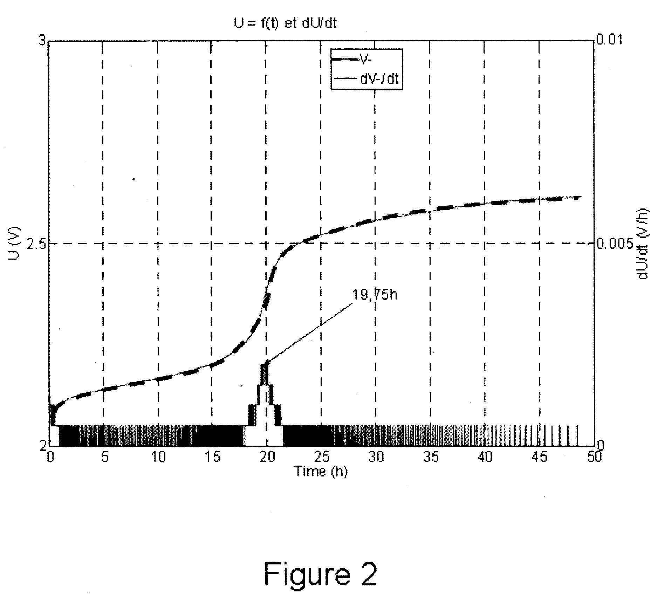

Lorsque tout le sulfate de plomb PbSO$_4$ est transformé en plomb, la batterie est dans un état chargé. La quantité de PbSO$_4$ transformé en plomb peut être déterminée, à partir de la durée de la réaction associée à l'équation (2), en utilisant la loi de Faraday dans le cadre de la coulométrie à courant constant. Cette loi est une méthode analytique utilisée couramment en électrochimie, et donc connue de l'homme du métier. L'analyse de la courbe de charge U=f(t) obtenue comme illustré à la figure 2, permet de déterminer la durée de la réaction de l'équation (2). La figure 2 illustre deux courbes respectivement représentatives de l'évolution dans le temps de la tension U(en Volt) au cours de la phase de charge à courant constant, et de l'évolution dans le temps de la dérivée dU/dt de la courbe de l'évolution de la tension. La durée de la réaction correspondant dans le cas présent au pic associé à 19,75h.

Ensuite, la masse de l'oxyde de plomb initialement présent avant imbibition peut être déterminée de manière conventionnelle par la stoechiométrie de l'équation (1).

Il résulte donc de l'analyse de ces deux réactions qu'en connaissant une valeur représentative de la quantité d'oxyde de plomb, il est possible de savoir quand l'accumulateur sera chargé au mieux.

Dès lors, la phase d'initialisation E1 peut comporter, comme illustré à la figure 1, une étape d'imbibition (E1-1) de l'accumulateur, avantageusement chargé sec, par son électrolyte, et une étape de mesure (E1-2), associée à l'imbibition, d'une élévation de la température de l'accumulateur, ou d'une valeur représentative de la densité de l'électrolyte, de sorte à déterminer la valeur représentative de la quantité d'oxyde de plomb présente avant l'imbibition. En fait, par « associée à l'imbibition », on entend que la valeur mesurée, d'élévation de température ou de valeur représentative de la densité, est fonction de la réaction chimique associée à l'imbibition, c'est-à-dire qu'elle résulte de l'étape d'imbibition. Typiquement, les mesures de l'élévation de température ou de la valeur représentative de la densité seront déterminées au cours de l'étape d'imbibition.

Par « valeur représentative de la densité », on entend dans la suite de la présente description soit une valeur de densité d'électrolyte directement mesurée, notamment après un laps de temps suite au début de l'étape d'imbibition, soit une diminution de la densité de l'électrolyte résultante de l'étape d'imbibition.

La mesure de l'élévation de température est avantageuse dans le cadre où la réaction de l'équation (1) est exothermique, et donc facilement mesurable, alors que la valeur représentative de la densité (induite par la réaction lors de l'imbibition) nécessite de prélever de l'électrolyte pour en déterminer la densité. Bien que la méthode mettant en oeuvre l'étude de la densité soit plus précise que la méthode mettant en oeuvre l'élévation de température, puisqu'on mesure une grandeur physique extensive qui est exclusivement caractéristique de l'électrolyte (les autres constituants de l'accumulateur ont une influence sur la montée en température), elle ne sera pas réalisable en continu car elle nécessite avantageusement plusieurs prises d'électrolyte consécutives juste après le remplissage et pendant l'imbibition, cette mesure la valeur représentative de la densité est donc plus difficile à automatiser. En fait, il est préférable de réaliser plusieurs mesures en continu après avoir ajouté l'électrolyte de sorte à être sûr que la densité n'évolue plus. En outre, la valeur représentative de la densité peut être fonction de la température de l'électrolyte, l'homme du métier sait appliquer le correctif idoine.

De manière générale, l'élévation de température, ou la diminution de densité, est représentative de la variation maximale de température ou de densité dûe à l'imbibition, c'est-à-dire lors de la réalisation de la réaction associée à l'équation (1). En fait, en connaissant la température initiale de l'accumulateur avant imbibition, ou la densité initiale de l'électrolyte avant imbibition, on cherche à mesurer ici la plus grande valeur de température, ou la plus petite valeur de densité, généralement représentative de la valeur correspondante obtenue lorsque la réaction de l'équation (1) est terminée. La variation maximale est alors obtenue par comparaison de la valeur initiale de température, ou le cas échéant la valeur initiale de densité, avec la valeur maximale de température, ou le cas échéant de la valeur minimale de densité.

Comme évoqué précédemment, au cours de l'étape d'imbibition, l'oxyde de plomb se transforme préférablement intégralement en PbSO$_4$. Ainsi de préférence, avant d'enclencher la phase de charge de l'accumulateur, il faudra attendre que la réaction associée à l'équation (1) soit terminée. Par exemple, cette réaction sera terminée lorsqu'une température maximum est atteinte et que la température tend à diminuer, ou lorsque la densité de l'électrolyte se sera stabilisée après un temps d'imprégnation d'au moins deux heures pour s'assurer que l'électrolyte a bien pénétré dans les porosités de la matière active de l'accumulateur.

Selon une mise en oeuvre particulière du procédé, la valeur représentative de la quantité d'oxyde de plomb correspond à un taux d'oxyde de plomb initial présent avant imbibition. Avantageusement, la durée de charge t$_{ch}$ en heure est donnée par l'équation suivante $t_{ch} = \dfrac{\%PbO \times 2 \times F \times m_T}{I \times M(PbO) \times 3600}$ (3), avec F la constante de Faraday, m$_T$ la masse totale de matière active négative de l'accumulateur notamment en gramme, M(PbO) la masse molaire de l'oxyde de plomb notamment en gramme par mole, I le courant de charge notamment en ampère, et %PbO le taux d'oxyde de plomb notamment en pourcentage.

La masse de matière active négative totale m$_T$ correspond à la matière empâtée sur des plaques de l'accumulateur formant l'anode. En fait, les plaques négatives d'un accumulateur comportent une grille de plomb métallique sur laquelle est empâtée la matière active (en fin de fabrication on a 92 à 94% de plomb plus des additifs variants selon les fabricants). La grille de plomb ainsi qu'une partie de la pâte ne participent pas aux réactions électrochimiques de charge ou de décharge, mais participent à la bonne conduction électrique de l'ensemble. La valeur de masse $m_T$ associée peut être connue pour un type d'accumulateur en prenant un accumulateur neuf de même type, puis en retirant la matière active empâtée sur toutes les plaques négatives de l'accumulateur de sorte à la peser. Bien entendu, cette information de valeur de masse peut être communiquée, le cas échéant, par les fabricants.

En fait, dans le cadre de la validation du procédé de charge utilisant le taux de PbO pour déterminer la durée de charge de la batterie, il a été réalisé des tests chimiques permettant de déterminer de manière théorique la quantité d'oxyde de plomb sur les plaques négatives à partir d'échantillons de matière empâtée prélevés sur une plaque négative d'autres accumulateurs. On parle « d'autres accumulateurs » car les prises d'échantillons pour réaliser les analyses chimiques sont destructrices pour ces accumulateurs, dès lors ces derniers ne peuvent ensuite plus être imbibés. Les résultats de ces tests ont servi de référence pour les comparaisons avec la détermination de la quantité d'oxyde de plomb déduite par coulométrie à courant constant.

Les tests chimiques ayant été réalisés sur des échantillons, et non pas sur la totalité de la masse $m_T$, le taux d'oxyde de plomb a été sélectionné comme critère de détermination de la durée de charge. Les résultats de la coulométrie à courant constant ont donc, pour des raisons de comparaison, aussi été exprimés en taux d'oxyde de plomb. Cependant, comme la coulométrie utilise l'ensemble de la matière négative active de l'accumulateur, il est nécessaire, dans l'exemple, de connaître la masse totale de matière active négative $m_T$ empâtée sur les plaques négatives d'un accumulateur neuf.

Ainsi, on comprend que l'utilisation du taux d'oxyde de plomb n'est qu'un mode de réalisation particulier permettant de déterminer une durée de charge optimum d'un accumulateur. Ainsi, on peut aussi considérer qu'il est possible d'évaluer cette durée de charge en reliant une élévation de température à une masse (à la place du taux) d'oxyde de plomb déterminée par la coulométrie à courant constant, et ce sans avoir à connaître la masse totale de matière active.

Ceci permettrait de déterminer la durée de charge optimisée par la formule suivante : $t_{ch} = \dfrac{m_{PbO} \times 2 \times F}{I \times M(PbO) \times 3600}$

où $m_{PbO}$ désigne la masse de PbO, en gramme, évaluée à l'aide d'un abaque associant la valeur d'élévation de température, ou la valeur représentative de la densité, à une masse de PbO. Néanmoins, en utilisant la masse, on perd une information de diagnostic sur l'ampleur de l'oxydation, par exemple, pour une valeur de 3 grammes de PbO, il est difficile de savoir si l'oxydation de l'accumulateur est réellement importante. Ainsi, le taux d'oxyde de plomb est préféré car il permet, par exemple par simple lecture d'un opérateur, de savoir si l'accumulateur présente une oxydation importante ou non.

De manière générale applicable à tout ce qui a été dit ci-dessus, la détermination de la valeur représentative de quantité d'oxyde de plomb peut être réalisée à partir d'un abaque donnant ladite valeur représentative de la quantité d'oxyde de plomb en fonction de l'élévation de la température de l'accumulateur, ou de la valeur représentative de la densité de l'électrolyte.

Selon une mise en oeuvre particulière, la durée de charge $t_{ch}$ de l'accumulateur peut être déterminée à partir d'un abaque donnant ladite durée en fonction de l'élévation de la température, ou de la valeur représentative de la densité, ladite élévation de température, ou la valeur représentative de la densité, étant corrélée à la valeur représentative de quantité d'oxyde de plomb. En fait, l'abaque peut correspondre à un tableau donnant différentes valeurs d'élévation de température, ou de valeurs représentatives de la densité, chacune associée à une valeur de temps de charge.

De manière générale, la charge de l'accumulateur est réalisée à courant constant. Ainsi, de préférence, l'abaque tient compte de cette valeur de courant. Il sera donc possible en fonction du courant d'avoir plusieurs valeurs possibles de temps de charge.

Selon une variante, l'abaque correspond à un simple coefficient multiplicateur qu'il suffit de multiplier par la valeur d'élévation de température pour obtenir le temps de charge. L'abaque peut aussi correspondre à une équation dont le résultat, en injectant la valeur mesurée d'élévation de température, ou la valeur représentative de la densité, donne la valeur représentative de la quantité d'oxyde de plomb présente avant imbibition, c'est-à-dire le cas échéant le temps de charge, ou le taux de PbO.

De manière générale applicable à toutes les réalisations du procédé de charge, au cours de la phase d'initialisation E1, l'imbibition est réalisée en remplissant d'un coup l'accumulateur par son électrolyte. Ceci permet, entre autre, d'obtenir une élévation de température maximale.

Il résulte de ce qui a été décrit ci-dessus qu'il est préférable de générer convenablement un abaque à associer au procédé de charge.

Ainsi, l'invention est aussi relative à un procédé de génération d'un abaque destiné à être utilisé dans le procédé de charge. Un tel procédé comporte la génération de l'abaque à partir d'au moins une mesure d'un paramètre physique d'un accumulateur au plomb au moins partiellement oxydé, et la corrélation de cette mesure à une valeur représentative d'une quantité d'oxyde de plomb dans l'accumulateur. Ce paramètre physique mesuré peut être l'élévation de température de l'accumulateur, ou la valeur représentative de la densité de l'électrolyte ajoutée lors de l'imbibition.

Le procédé de génération de l'abaque pourra être réalisé à partir d'au moins un accumulateur étalon, notamment stocké chargé sec, et représentatif du type d'accumulateur qui sera plus tard utilisé dans le procédé de charge. Par type d'accumulateur, on entend des accumulateurs ayant les mêmes caractéristiques physiques.

Avantageusement, dans le cadre d'un abaque mettant en oeuvre l'élévation de température, un seul accumulateur étalon peut suffire. Dans le cadre d'un abaque mettant en oeuvre la valeur représentative de la densité, on utilisera avantageusement deux accumulateurs étalons.

Par la suite, les tests initiaux qui ont permis de montrer la possibilité d'établir l'abaque ont été réalisés sur un lot de 9 accumulateurs étalon chargés secs de même type, et de marque Exide 12 OPzS 1200LA comprenant trois accumulateurs récents non stockés (Ref-01 à Ref-03), c'est-à-dire peu oxydés, et six accumulateurs ayant été entreposés hors limites de durée, et dans des conditions de stockage non contrôlées (A-05 à A-07 et B-09 à B-11), c'est-à-dire potentiellement fortement oxydés.

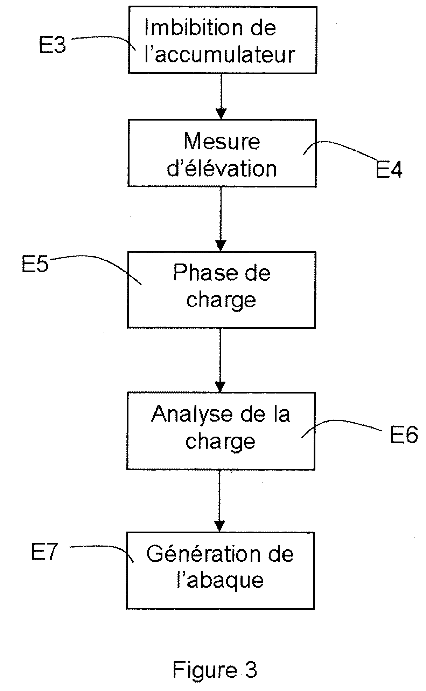

Avantageusement, le procédé de génération de l'abaque comporte différentes étapes de test comme illustré à la figure 3.

Dans un premier temps, on réalise une imbibition E3 de l'accumulateur en le remplissant d'électrolyte de sorte que l'oxyde de plomb se transforme intégralement en $PbSO_4$. Cette imbibition permet de réaliser la réaction de l'équation (1). On mesure E4 alors une élévation de température de l'accumulateur, ou une valeur représentative de la densité de l'électrolyte, associée à l'imbibition.

Dans un deuxième temps, on réalise une phase de charge E5 de l'accumulateur. Cette phase de charge est, préférentiellement, réalisée uniquement lorsque la réaction associée à l'équation (1) est terminée. Cette phase de charge est en outre analysée E6.

Enfin, l'abaque est généré E7 à partir de l'analyse de la phase de charge, et de l'élévation de température de l'accumulateur, ou de la valeur représentative de la densité de l'électrolyte.

Selon une mise en oeuvre particulière, la phase de charge E5 est réalisée à courant constant avec mesure de l'évolution de la tension aux bornes de l'accumulateur. L'étape d'analyse E6 de la phase de charge permet d'une part de déterminer, à partir de l'évolution de la tension au cours de la phase de charge, la quantité de $PbSO_4$ transformé en plomb (voir précédemment pour la méthode), et d'autre part de déterminer, à partir d'une équation de réaction chimique (notamment l'équation (1)) et de la quantité de $PbSO_4$ transformé en plomb, la quantité initiale d'oxyde de plomb avant imbibition, de sorte que la génération de l'abaque prenne en compte la quantité initiale d'oxyde de plomb avant imbibition.

En fait, selon cette mise en oeuvre la quantité initiale d'oxyde de plomb avant imbibition peut être déterminée comme décrit précédemment notamment en utilisant la figure 2 et les équations (1) et (2).

Cette quantité d'oxyde de plomb peut avantageusement être un taux d'oxyde de plomb.

Dès lors, l'abaque peut être généré de sorte à donner la valeur représentative de la quantité d'oxyde de plomb en fonction de l'élévation mesurée de température, ou de la valeur représentative de la densité mesurée.

La table I ci-dessous permet de corréler une élévation de température $\Delta T$ à un taux d'oxyde de plomb pour les différents accumulateurs étalons évoqués ci-dessus après que les étapes de test aient été réalisées pour chaque accumulateur étalon.

Table I

| Élément | Ref-01 | Ref-02 | Ref-03 | A-05 | A-06 | A-07 | B-09 | B-10 | B-11 |
|---|---|---|---|---|---|---|---|---|---|
| $\Delta T$ (°C) | + 1 | + 2 | + 2 | + 15 | + 15 | + 12 | +26 | + 14 | + 14 |
| % PbO | 4,1 | 6,2 | 5,7 | 24,9 | 24,4 | 19,7 | > 30 | 22,6 | 26,7 |

Cette table peut ensuite être utilisée pour un même type d'accumulateur chargé sec que l'on souhaite initialiser en le remplissant d'électrolyte. Typiquement au cours du procédé de charge, connaissant l'élévation de température, il est possible de déterminer le taux d'oxyde de plomb à partir de la table I, puis de l'injecter dans l'équation (3) pour déterminer la durée de charge de l'accumulateur. Autrement dit, l'abaque peut être généré de sorte à donner un taux d'oxyde de plomb en fonction d'une élévation de température mesurée, ou de la valeur représentative de la densité mesurée.

Selon une variante, l'abaque est généré de sorte à donner une durée de charge en fonction de l'élévation de température mesurée, ou la valeur représentative de la densité mesurée. Cette variante peut être mise en oeuvre en combinant la table I à la table II ci-dessous donnant le temps de charge en heure en fonction du taux d'oxyde de plomb.

Table II

| Élément | Ref-01 | Ref-02 | Ref-03 | A-05 | A-06 | A-07 | B-09 | B-10 | B-11 |
|---|---|---|---|---|---|---|---|---|---|
| % PbO | 4,1 | 6,2 | 5,7 | 24,9 | 24,4 | 19,7 | > 30 | 22,6 | 26,7 |

(suite)

| Élément | Ref-01 | Ref-02 | Ref-03 | A-05 | A-06 | A-07 | B-09 | B-10 | B-11 |
|---------|--------|--------|--------|------|------|------|------|------|------|
| t en h  | 1,6    | 2,4    | 2,2    | 9,6  | 9,4  | 7,6  | > 18 | 8,7  | 10,3 |

Cette table II peut être obtenue en utilisant la table I et à partir de l'équation (3) au cours du procédé de génération de l'abaque. Ceci aura pour avantage de rendre le procédé de charge plus simple à mettre en oeuvre puisque tous les calculs auront été réalisés au cours de la génération de l'abaque, et qu'une simple lecture de l'abaque pourra suffire lors de la réalisation du procédé de charge pour déterminer la durée de charge.

De manière générale, l'abaque est complété par répétition des étapes de tests à différentes oxydations de sorte à générer une pluralité de données. Ces étapes de tests pourront être réalisées sur différents accumulateurs étalons de même type comme réalisé ci-dessus pour les accumulateurs étalons référencés Ref-01 à 03, A-06 à 07 et B-09 à 11.

Bien que les tables aient été générées en prenant en compte le taux de l'élévation de température, le même principe peut s'appliquer en générant des tables prenant en compte la valeur représentative de la densité.

Selon une mise en oeuvre préférentielle, les étapes de test sont répétées, notamment sur différents accumulateurs de même type chargés secs, de sorte à obtenir une pluralité de couples incluant la valeur représentative de la quantité d'oxyde de plomb et une valeur d'élévation mesurée de température, ou une valeur représentative de la densité mesurée. A partir des couples, une étape de détermination d'une équation, notamment de droite, par régression linéaire peut être réalisée de sorte que l'abaque ne comporte qu'une unique équation, permettant au cours du procédé de charge de déterminer la valeur représentative de la quantité d'oxyde de plomb en injectant simplement dans ladite équation la valeur mesurée d'élévation de température de l'accumulateur, ou la valeur représentative de la densité mesurée de l'électrolyte.

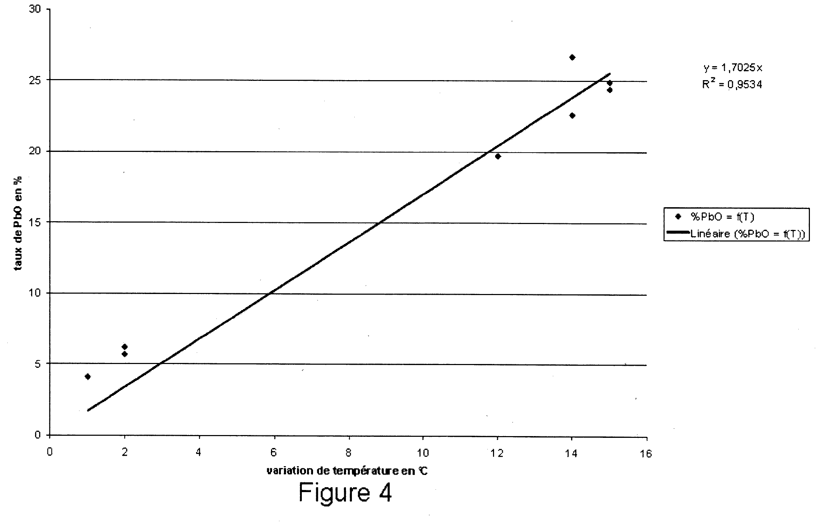

Cette mise en oeuvre préférentielle peut être visualisée à la figure 4 où les couples de taux de PbO en % en fonction de l'élévation de température en °C ont été placés selon des points, et associés à une droite déterminée par régression linéaire à partir desdits points. Ainsi, à partir de la figure 4, le taux de PbO est égal à 1,7 fois l'élévation de température car dans ce cas précis, l'équation de droite est $y=1,7025x$. $R^2$ correspond au coefficient de corrélation de la régression linéaire, plus il se rapproche de 1 (il est toujours inférieur ou égal à 1) plus la régression linéaire modélisant les données est pertinente.

Sur la figure 4, l'équation de la droite est une équation passant par l'origine. Précédemment, il a été évoqué qu'un seul accumulateur pouvait être suffisant. Ceci est dû au fait que cette droite passe par l'origine. En effet, dans le cadre d'une simplification de la caractérisation des accumulateurs, en testant un seul accumulateur, et en générant un graphique du type de la figure 4 avec une droite passant par le point issu de l'unique test et par l'origine du graphique, il est possible de déterminer l'équation de la droite. Bien que ceci permette de faciliter les calculs, cette réalisation n'est pas avantageuse car elle ne permet pas de lisser les éventuels défauts d'un accumulateur.

En utilisant cette relation de 1,7, on peut estimer le taux de PbO de l'élément B-09 ($\Delta T$ = +26°C) à une valeur d'environ 44%. Cela signifie qu'avec une charge à courant constant de 70 A, il suffit de 18 heures pour atteindre la charge complète de cet accumulateur (application de l'équation 3 dans le cas où $m_T$ est connu). Il est préférable de prévoir un léger complément de charge (1 à 2 heures supplémentaires) pour déstratifier l'électrolyte par dégazage. Ceci est avantageux car à 70 A, les préconisations des fournisseurs incluant une marge de sécurité trop importante sont plutôt de l'ordre de 48h.

S'agissant d'une droite passant par l'origine, il est possible, dans le cadre de l'élévation de température que l'abaque corresponde à un coefficient multiplicateur donnant directement le temps de charge en heures une fois multiplié à l'élévation de température lors de la phase d'initialisation du procédé de charge d'un accumulateur.

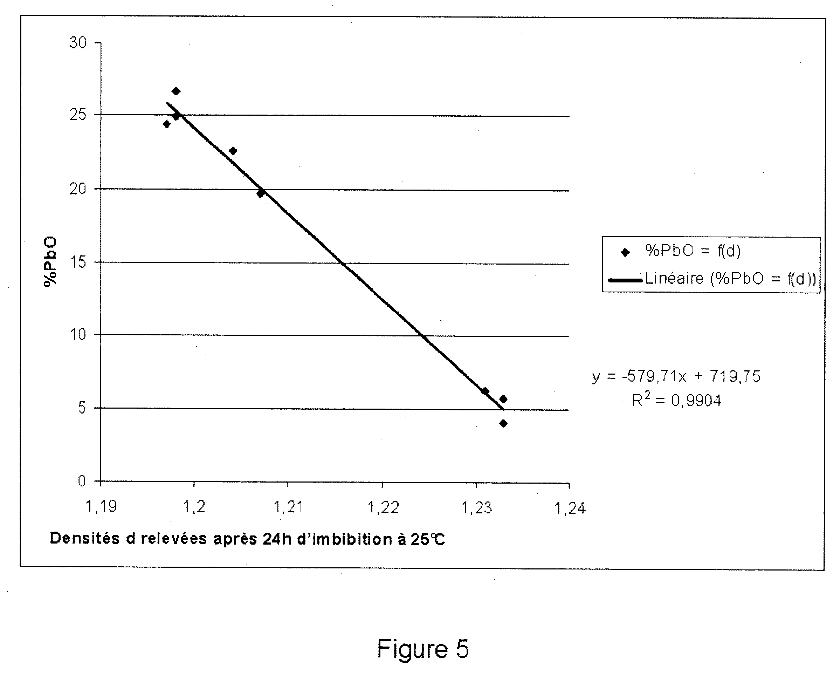

Bien entendu cette régression linéaire peut aussi être mise en oeuvre pour la valeur représentative de densité de l'électrolyte comme illustré à la figure 5 donnant l'évolution du taux de PbO en % en fonction de la densité. La valeur de densité d'un point du graphique correspond à la densité mesurée après 24h d'imbibition lorsque la température de l'accumulateur est revenue à la température ambiante, soit 25°C dans l'exemple particulier. Les différents points du graphique sont obtenus en testant différents accumulateurs de même type. Les valeurs les plus faibles de densité mesurées correspondent à un transfert de masse des ions sulfates depuis l'électrolyte vers les plaques négatives, ce transfert est d'autant plus important que les plaques sont initialement oxydées avant imbibition. Selon la droite obtenue $y= -579x+719,75$, on a le taux de PbO qui est égal à -579,71 fois la densité plus 719,75. $R^2$ correspond au coefficient de corrélation de la régression linéaire. Il est possible de mesurer la densité plus tôt, c'est-à-dire sans attendre 24 heures, mais il faut laisser passer au moins deux heures après avoir ajouté l'électrolyte pour s'assurer que l'électrolyte a bien pénétré la totalité de la porosité de la matière active.

On aura compris que dans le cadre de la figure 5, la droite ne passe pas par l'origine. C'est pour cela qu'il est avantageux de réaliser les tests sur au moins deux accumulateurs de sorte à générer la droite par exemple uniquement en fonction de ces deux points pour faciliter la génération de l'abaque en évitant la régression linéaire à partir de plusieurs tests. Bien entendu, dans ce cas particulier, la moindre erreur dans les mesures donnera lieu à l'établissement d'une équation de droite faussée.

Lorsque la valeur représentative de la quantité d'oxyde de plomb est un taux d'oxyde de plomb, le procédé de génération de l'abaque peut comporter une étape de détermination d'une masse de matière active négative totale $m_T$ associée à l'accumulateur, et la déduction du taux d'oxyde de plomb à partir de la masse de matière active totale $m_T$ et de la quantité initiale d'oxyde de plomb déterminée. $m_T$ peut être déterminée comme décrit précédemment en ouvrant un accumulateur neuf de même type et en l'étudiant.

Notons que dès que la masse totale de matière active $m_T$ (qui dépend du type d'accumulateur) est connue, on peut utiliser des abaques ne dépendant plus que du courant utilisé et de la mesure d'évolution de la température de l'accumulateur, ou de la densité de l'électrolyte fournissant $m_{PbO}$ (la durée de charge étant alors ensuite calculée en application de $t_{ch} = \dfrac{m_{PbO} \times 2 \times F}{I \times M(PbO) \times 3600}$ ).

Il a été précisé précédemment que l'électrolyte était généralement ajouté d'un coup lors de la phase d'initialisation du procédé de charge, ou lors de l'imbibition dans le procédé de génération de l'abaque. Si on ajoute en une seule fois, et rapidement, la totalité de l'électrolyte, la hausse de température va être importante et favoriser momentanément la réaction d'autodécharge de l'accumulateur. Cette dernière transforme une petite partie du plomb en sulfate de plomb et s'accompagne d'un dégagement gazeux de dihydrogène. A température ambiante cette réaction a également lieu, mais elle est très défavorisée cinétiquement (il faut environ 1 mois pour que 5% de la matière active subisse cette réaction à température ambiante). La cinétique suit une loi exponentielle en fonction de la température, qui voit doubler sa vitesse pour une augmentation de 10°C de la température. Durant les tests, la température a pu augmenter de plus de 20°C pendant une quinzaine d'heure ce qui correspond à une attaque de 0,1% de la matière active négative, valeur donc négligeable dans le cadre de la présente invention.

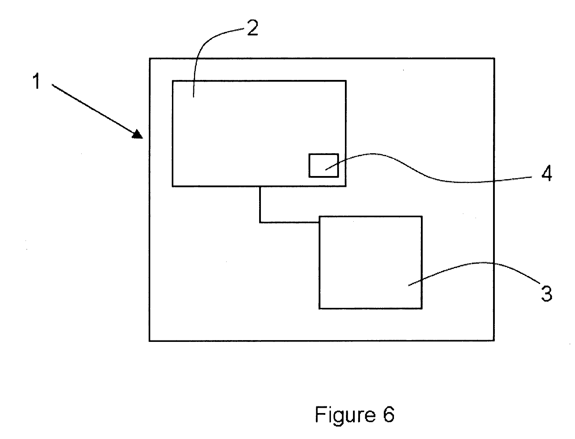

Dans le cadre de la mise en oeuvre du procédé de charge un dispositif 1 illustré à la figure 6 peut comprendre un accumulateur 2 et une unité de calcul 3 configurée pour réaliser le procédé de charge. En outre dans le mode de réalisation où l'on cherche à mesurer une élévation de température, le dispositif peut comprendre un capteur de température 4, notamment de type thermocouple, configuré pour mesurer l'élévation de la température de l'accumulateur au cours de la phase d'initialisation. Ce capteur sera avantageusement installé à un point médian des faces latérales extérieures d'un bac perpendiculaire aux plaques. Le capteur peut aussi être placé dans l'électrolyte mais devra résister à de l'acide sulfurique. Ce capteur de température peut en parallèle être associé à un boitier comprenant une carte électronique implémentée par l'abaque et incluant un algorithme pour le calcul du taux de plomb estimé. À partir de la durée de charge déduite (abaque type tableau II), il est possible d'envisager de déclencher automatiquement la charge correspondante. La présence d'un opérateur n'est alors nécessaire que pour la pause du capteur et le remplissage de l'accumulateur. La carte électronique peut être implémentée par de multiples abaques correspondants à différents type d'accumulateurs envisagés, permettant ainsi d'adapter facilement le dispositif à différents accumulateurs.

Un support d'enregistrement de données lisible par un calculateur, sur lequel est enregistré un programme informatique peut comprendre des moyens de codes de programme informatique de mise en oeuvre des étapes et/ou phases du procédé de charge (de préférence toutes les étapes et/ou phases du procédé de charge).

Un programme informatique peut comprendre un moyen de codes de programme informatique adapté à la réalisation des étapes et/ou phases du procédé de charge (de préférence toutes les étapes et/ou phases du procédé de charge), lorsque le programme est exécuté par un calculateur.

Un tel procédé de charge est intéressant pour des activités impliquant le stockage d'accumulateurs au plomb chargés secs sur une durée importante, durée pouvant dépasser les préconisations des fournisseurs. La méthode permet d'établir rapidement un diagnostic sur l'état de santé des accumulateurs, et d'optimiser leur première charge après remplissage de l'électrolyte, de sorte à ne pas les dégrader.

Lors du procédé de charge, si la batterie n'est que faiblement oxydée, on ne cherchera pas à calculer un temps de charge de manière optimisé. Ainsi, par exemple si l'élévation de température au cours de l'imbibition est inférieure à 5°C, voire inférieure à 3°C, on appliquera systématiquement un temps de charge prédéterminé. Par exemple, pour un accumulateur de marque Exide 12 OPzS 1200 pour une charge à 70A la durée de charge sera de 8 heures pour retrouver immédiatement la capacité nominale initiale de l'accumulateur.

Dans la présente description on entend par « accumulateur » tant un accumulateur élémentaire qu'une pluralité d'accumulateurs élémentaires organisés et reliés électriquement pour former une batterie.

**Revendications**

1. Procédé de charge d'un accumulateur au plomb comprenant une phase d'initialisation (E1) au cours de laquelle une valeur représentative d'une quantité d'oxyde de plomb de la matière active négative de l'accumulateur correspondant à une quantité d'oxyde de plomb formée à la surface de la matière active négative d'un accumulateur au plomb chargé sec lors de son stockage est déterminée, et une phase de charge (E2) dont la durée est déterminée en fonction de la valeur représentative de quantité d'oxyde de plomb, **caractérisé en ce que** la phase d'initialisation (E1) comporte une étape d'imbibition (E1-1) de l'accumulateur par son électrolyte et une étape de mesure (E1-2), associée à l'imbibition, d'une élévation de la température de l'accumulateur, ou d'une valeur représentative de la densité de l'électrolyte, de sorte à déterminer la valeur représentative de la quantité d'oxyde de plomb présente avant l'imbibition, cette détermination étant réalisée à partir d'un abaque donnant ladite valeur représentative de la quantité d'oxyde de plomb en fonction de l'élévation de la température, ou de la valeur représentative de la densité.

2. Procédé selon la revendication 1, **caractérisé en ce qu'**au cours de l'étape d'imbibition (E1-1), l'oxyde de plomb se transforme intégralement en $PbSO_4$.

3. Procédé selon la revendication précédente, **caractérisé en ce que** :

   - la valeur représentative de la quantité d'oxyde de plomb correspond à un taux d'oxyde de plomb initial présent avant imbibition,
   - la durée de charge $t_{ch}$ en heure est donnée par l'équation suivante $t_{ch}$= [%PbO x 2 x F x $m_T$] / [I x M(PbO) x 3600], , avec F la constante de Faraday, $m_T$ la masse totale de matière active négative de l'accumulateur, M(PbO) la masse molaire de l'oxyde de plomb, I le courant de charge, et %PbO le taux d'oxyde de plomb.

4. Procédé selon la revendication 1, **caractérisé en ce que** la durée de charge est déterminée à partir d'un abaque donnant ladite durée de charge en fonction de l'élévation de la température, ou de la valeur représentative de la densité, ladite élévation de la température, ou la valeur représentative de la densité, étant corrélée à la valeur représentative de quantité d'oxyde de plomb.

5. Procédé selon l'une quelconque des revendications 1 à 4, **caractérisé en ce que** au cours de la phase d'initialisation, l'imbibition est réalisée en remplissant d'un coup l'accumulateur par son électrolyte.

6. Procédé de génération d'un abaque destiné à être utilisé dans le procédé selon l'une des revendications 1 à 5, **caractérisé en ce qu'**il comporte la génération de l'abaque à partir d'au moins une mesure d'un paramètre physique d'un accumulateur au plomb au moins partiellement oxydé, et la corrélation de cette mesure à une valeur représentative d'une quantité d'oxyde de plomb de la matière active négative de l'accumulateur et **caractérisé en ce qu'**il comporte les étapes de test suivantes :

   - Réaliser une imbibition (E3) de l'accumulateur en le remplissant d'électrolyte de sorte que l'oxyde de plomb se transforme intégralement en $PbSO_4$,
   - Mesurer (E4) une élévation de température de l'accumulateur, ou une valeur représentative de la densité de l'électrolyte, associée à l'imbibition,
   - Réaliser une phase de charge (E5) de l'accumulateur,
   - Analyser (E6) la phase de charge,
   - Générer (E7) l'abaque à partir de l'analyse de la phase de charge, et de l'élévation de température de l'accumulateur, ou de la valeur représentative de la densité de l'électrolyte.

7. Procédé selon la revendication 6, **caractérisé en ce que** la phase de charge (E5) est réalisée à courant constant avec mesure de l'évolution de la tension aux bornes de l'accumulateur, et **en ce que** l'étape d'analyse (E6) de la phase de charge (E5) permet d'une part de déterminer, à partir de l'évolution de la tension au cours de la phase de charge (E5), la quantité de $PbSO_4$ transformé en plomb, et d'autre part de déterminer, à partir d'une équation de réaction chimique et de la quantité de $PbSO_4$ transformé en plomb, la quantité initiale d'oxyde de plomb avant imbibition, de sorte que la génération de l'abaque prenne en compte la quantité initiale d'oxyde de plomb avant imbibition.

8. Procédé selon l'une des revendications 6 ou 7, **caractérisé en ce que** l'abaque est généré de sorte à donner la valeur représentative de la quantité d'oxyde de plomb en fonction de l'élévation de température mesurée, ou de la valeur représentative de la densité mesurée.

**9.** Procédé selon l'une des revendications 6 ou 7, **caractérisé en ce que** l'abaque est généré de sorte à donner une durée de charge en fonction de l'élévation de température mesurée, ou la valeur représentative de la densité mesurée.

**10.** Procédé selon l'une des revendications 8 à 9, **caractérisé en ce que** l'abaque est complété par répétition des étapes de tests à différentes oxydations de sorte à générer une pluralité de données.

**11.** Procédé selon l'une des revendications 6 à 10, **caractérisé en ce que** les étapes de test sont répétées de sorte à obtenir une pluralité de couples incluant la valeur représentative de la quantité d'oxyde de plomb et une valeur d'élévation mesurée de température, ou une valeur représentative de la densité mesurée, et **en ce qu'**il comporte, à partir des couples, une étape de détermination d'une équation par régression linéaire de sorte que l'abaque ne comporte qu'une unique équation.

**12.** Procédé selon la revendication 8 et l'une des revendications 8 à 11, **caractérisé en ce que** la valeur représentative de la quantité d'oxyde de plomb est un taux d'oxyde de plomb, et **en ce que** procédé comporte une étape de détermination d'une masse de matière active négative totale $m_T$ associée à l'accumulateur, et la déduction du taux d'oxyde de plomb à partir de la masse de matière active totale $m_T$ et de la quantité initiale d'oxyde de plomb déterminée.

**13.** Dispositif (1) comprenant un accumulateur (2), **caractérisé en ce qu'**il comprend une unité de calcul (3) configurée pour réaliser le procédé selon l'une des revendications 1 à 5, et un capteur de température (4), notamment de type thermocouple, configuré pour mesurer l'élévation de la température au cours de la phase d'initialisation.

**14.** Support d'enregistrement de données lisible par un calculateur, sur lequel est enregistré un programme informatique comprenant des moyens de codes de programme informatique de mise en oeuvre des phases et/ou étapes d'un procédé selon l'une des revendications 1 à 5.

**Patentansprüche**

**1.** Verfahren zum Laden einer Bleisäurebatterie, umfassend eine Initialisierungsphase (E1), während der ein Wert, der für eine Menge an Bleioxid des negativen aktiven Materials der Batterie repräsentativ ist, die einer Menge an Bleioxid entspricht, die auf der Oberfläche des negativen aktiven Materials einer trockenen, geladenen Bleisäurebatterie während ihrer Lagerung gebildet wird, bestimmt wird, und eine Ladephase (E2), deren Dauer in Abhängigkeit von dem Wert bestimmt wird, der für die Menge an Bleioxid repräsentativ ist, **dadurch gekennzeichnet, dass** die Initialisierungsphase (E1) einen Schritt des Durchtränkens (E1-1) der Batterie mit ihrem Elektrolyten und einen Schritt des Messens (E1-2), der mit dem Durchtränken verbunden ist, einer Temperaturerhöhung der Batterie oder eines Wertes, der für die Elektrolytdichte repräsentativ ist, derart aufweist, um den Wert zu bestimmen, der für die Menge an Bleioxid repräsentativ ist, die vor dem Durchtränken vorhanden ist, wobei dieses Bestimmen ausgehend von einer graphischen Darstellung durchgeführt wird, die den Wert angibt, der für die Menge an Bleioxid in Abhängigkeit von der Temperaturerhöhung oder von dem Wert, der für die Dichte repräsentativ ist, repräsentativ ist.

**2.** Verfahren nach Anspruch 1, **dadurch gekennzeichnet, dass** sich während des Schrittes des Durchtränkens (E1-1) das Bleioxid vollständig in $PbSO_4$ verwandelt.

**3.** Verfahren nach dem vorhergehenden Anspruch, **dadurch gekennzeichnet, dass**:

- der Wert, der für die Menge an Bleioxid repräsentativ ist, einem anfänglichen Bleioxidgehalt entspricht, der vor dem Durchtränken vorhanden ist,
- die Ladedauer $t_{ch}$ in Stunden durch die folgende Gleichung gegeben ist

$$t_{ch} = [\%PbO \times 2 \times F \times m_T]/[I \times M(PbO) \times 3600],$$

wobei F die Faraday-Konstante ist,
$m_T$ die Gesamtmasse des negativen aktiven Materials der Batterie ist,
M(PbO) die Molmasse des Bleioxids, I der Ladestrom und %PbO der Bleioxidgehalt ist.

4. Verfahren nach Anspruch 1, **dadurch gekennzeichnet, dass** die Ladedauer ausgehend von einer graphischen Darstellung bestimmt wird, die die Ladedauer in Abhängigkeit von der Temperaturerhöhung oder von dem Wert, der für die Dichte repräsentativ ist, angibt, wobei die Temperaturerhöhung oder der Wert, der für die Dichte repräsentativ ist, mit dem Wert korreliert wird, der für die Menge an Bleioxid repräsentativ ist.

5. Verfahren nach einem der Ansprüche 1 bis 4, **dadurch gekennzeichnet, dass** das Durchtränken während der Initialisierungsphase durchgeführt wird, indem die Batterie auf einen Schlag mit ihrem Elektrolyten gefüllt wird.

6. Verfahren zur Erzeugung einer graphischen Darstellung, die dazu bestimmt ist, in dem Verfahren nach einem der Ansprüche 1 bis 5 verwendet zu werden, **dadurch gekennzeichnet, dass** es das Erzeugen der graphischen Darstellung ausgehend von mindestens einer Messung eines physikalischen Parameters von einer Bleisäurebatterie, die mindestens teilweise oxidiert ist, und der Korrelation dieser Messung mit einem Wert, der für eine Menge an Bleioxid des negativen aktiven Materials der Batterie repräsentativ ist, aufweist, und dass es die folgenden Prüfschritte aufweist:

- Durchführen eines Durchtränkens (E3) der Batterie, indem sie derart mit Elektrolyt gefüllt wird, dass sich das Bleioxid vollständig in PbSO$_4$ verwandelt,
- Messen (E4) einer Temperaturerhöhung der Batterie oder eines Wertes, der für die Elektrolytdichte repräsentativ ist, der mit dem Durchtränken verbunden ist,
- Durchführen einer Ladephase (E5) der Batterie,
- Analysieren (E6) der Ladephase,
- Erzeugen (E7) der graphischen Darstellung ausgehend von der Analyse der Ladephase und der Temperaturerhöhung der Batterie oder von dem Wert, der für die Elektrolytdichte repräsentativ ist.

7. Verfahren nach Anspruch 6, **dadurch gekennzeichnet, dass** die Ladephase (E5) mit konstantem Strom mit Messung der Spannungsentwicklung an den Klemmen der Batterie durchgeführt wird und dass der Schritt des Analysierens (E6) der Ladephase (E5) ermöglicht, einerseits ausgehend von der Spannungsentwicklung im Laufe der Ladephase (E5) die Menge an PbSO$_4$ zu bestimmen, das sich in Blei verwandelt hat, und andererseits ausgehend von einer chemischen Reaktionsgleichung und von der Menge an PbSO$_4$, das sich in Blei verwandelt hat, die anfängliche Menge an Bleioxid vor dem Durchtränken derart zu bestimmen, dass das Erzeugen der graphischen Darstellung die anfängliche Menge an Bleioxid vor dem Durchtränken berücksichtigt.

8. Verfahren nach einem der Ansprüche 6 oder 7, **dadurch gekennzeichnet, dass** die graphische Darstellung derart erzeugt wird, um den Wert, der für die Menge an Bleioxid repräsentativ ist, in Abhängigkeit von der gemessenen Temperaturerhöhung oder dem Wert anzugeben, der für die gemessene Dichte repräsentativ ist.

9. Verfahren nach einem der Ansprüche 6 oder 7, **dadurch gekennzeichnet, dass** die graphische Darstellung derart erzeugt wird, um eine Ladedauer in Abhängigkeit von der gemessenen Temperaturerhöhung oder dem Wert anzugeben, der für die gemessene Dichte repräsentativ ist.

10. Verfahren nach einem der Ansprüche 8 bis 9, **dadurch gekennzeichnet, dass** die graphische Darstellung durch Wiederholen der Prüfschritte bei verschiedenen Oxidationen derart vervollständigt wird, um mehrere Daten zu erzeugen.

11. Verfahren nach einem der Ansprüche 6 bis 10, **dadurch gekennzeichnet, dass** die Prüfschritte derart wiederholt werden, um mehrere Paare zu erhalten, die den Wert, der für die Menge an Bleioxid repräsentativ ist, und einen Wert der gemessenen Temperaturerhöhung oder einen Wert, der für die gemessene Dichte repräsentativ ist, einschließen, und dass es ausgehend von den Paaren einen Schritt des Bestimmens einer Gleichung durch lineare Regression derart aufweist, dass die graphische Darstellung nur eine einzige Gleichung aufweist.

12. Verfahren nach Anspruch 8 und einem der Ansprüche 8 bis 11, **dadurch gekennzeichnet, dass** der Wert, der für die Menge an Bleioxid repräsentativ ist, ein Bleioxidgehalt ist, und dass das Verfahren einen Schritt des Bestimmens einer Gesamtmasse des negativen aktiven Materials m$_T$, die mit der Batterie verbunden ist, und das Ableiten des Bleioxidgehalts ausgehend von der Gesamtmasse des aktiven Materials m$_T$ und der bestimmten anfänglichen Menge an Bleioxid aufweist.

13. Vorrichtung (1), umfassend eine Batterie (2), **dadurch gekennzeichnet, dass** sie eine Recheneinheit (3), die konfiguriert ist, um das Verfahren nach einem der Ansprüche 1 bis 5 durchzuführen, und einen Temperatursensor (4) aufweist, insbesondere vom Typ des Thermoelements, der konfiguriert ist, um die Temperaturerhöhung während der Initialisierungsphase zu messen.

14. Rechnerlesbares Aufzeichnungsmedium von Daten, auf dem ein Computerprogramm gespeichert ist, das Computerprogrammcodemittel zum Umsetzen der Phasen und/oder Schritte eines Verfahrens nach einem der Ansprüche 1 bis 5 aufweist.

**Claims**

1. Process for charging a lead battery, comprising an initialisation phase (E1), during which a value representative of an amount of lead oxide of the negative active material of the battery corresponding to the amount of lead oxide formed at the surface of the said negative active material of a dry charged lead battery during its storage is determined, and a charging phase (E2), the duration of which is determined as a function of the value representative of amount of lead oxide, **characterized in that** the initialisation phase (E1) comprises a stage of impregnation (E1-1) of the battery by its electrolyte and a stage of measurement (E1-2), associated with the impregnation, of a rise in the temperature of the battery or of a value representative of the density of the electrolyte, so as to determine the value representative of the amount of lead oxide present before the impregnation, said determination being carried out starting from a nomogram giving the said value representative of the amount of lead oxide as a function of the rise in the temperature, or of the value representative of the density.

2. Process according to Claim 1, **characterized in that**, during the impregnation stage (E1-1), the lead oxide is converted in full into $PbSO_4$.

3. Process according to the preceding Claim, **characterized in that**:

   - the value representative of the amount of lead oxide corresponds to an initial rate of lead oxide present before impregnation.

   - the charging time $t_{ch}$ in hours is given by the following equation $t_{ch} = \dfrac{\%PbO \times 2 \times F \times w_T}{I \times M(PbO) \times 3600}$ , with F the Faraday constant, $w_T$ the total weight of negative active material of the battery, M(PbO) the molar mass of the lead oxide, I the charging current and %PbO the rate of lead oxide.

4. Process according to Claim 1, **characterized in that** the charging time is determined from a nomogram giving said charging time as a function of the rise in the temperature or of the value representative of the density, the said rise in the temperature or the value representative of the density being correlated with the value representative of amount of lead oxide.

5. Process according to any one of Claims 1 to 4, **characterized in that**, during the initialisation phase, the impregnation is carried out by filling, in one go, the battery with its electrolyte.

6. Process for the generation of a nomogram intended to be used in the process according to one of Claims 1 to 5, **characterized in that** it comprises the generation of the nomogram from at least one measurement of a physical parameter of an at least partially oxidized lead battery and the correlation of this measurement with a value representative of an amount of lead oxide of the negative active material of the battery and **characterized in that** it comprises the following test stages:

   - Carrying out an impregnation (E3) of the battery by filling it with electrolyte so that the lead oxide is converted in full into $PbSO_4$,
   - Measuring (E4) a rise in temperature of the battery or a value representative of the density of the electrolyte, associated with the impregnation,
   - Carrying out a phase (E5) of charging the battery,
   - Analysing (E6) the charging phase,
   - Generating (E7) the nomogram from the analysis of the charging phase, and the rise in temperature of the battery, or the value representative of the density of the electrolyte.

7. Process according to Claim 6, **characterized in that** the charging phase (E5) is carried out with a constant current with measurement of the change in the voltage at the terminals of the battery and **in that** the stage (E6) of analysis of the charging phase (E5) makes it possible, on the one hand, to determine, from the change in the voltage during the charging phase (E5), the amount of $PbSO_4$ converted into lead and, on the other hand, to determine, from a chemical reaction equation and from the amount of $PbSO_4$ converted into lead, the initial amount of lead oxide before impregnation, so that the generation of the nomogram takes into account the initial amount of lead oxide before impregnation.

8. Process according to either of Claims 6 and 7, **characterized in that** the nomogram is generated so as to give the value representative of the amount of lead oxide as a function of the measured rise in temperature or of the value representative of the density measured.

9. Process according to either of Claims 6 and 7, **characterized in that** the nomogram is generated so as to give a charging time as a function of the measured rise in temperature or of the value representative of the density measured.

10. Process according to either of Claims 8 and 9, **characterized in that** the nomogram is completed by repeating the test stages at different oxidations so as to generate a plurality of data.

11. Process according to one of Claims 6 to 10, **characterized in that** the test stages are repeated so as to obtain a plurality of pairs including the value representative of the amount of lead oxide and a value for measured rise in temperature or a value representative of the density measured, and **in that** it comprises, from the pairs, a stage of determination of an equation by linear regression so that the nomogram comprises only a single equation.

12. Process according to Claim 8 and one of Claims 8 to 11, **characterized in that** the value representative of the amount of lead oxide is a rate of lead oxide, and **in that** the process comprises a stage of determination of a total weight of negative active material $w_T$ associated with the battery and the deduction of the rate of lead oxide from the total weight of active material $w_T$ and the initial amount of lead oxide determined.

13. Device (1) comprising a battery (2), **characterized in that** it comprises a calculation unit (3) configured in order to carry out the process according to one of Claims 1 to 5, and a temperature sensor (4), in particular of thermocouple type, configured in order to measure the rise in the temperature during the initialisation phase.

14. Data recording medium readable by a computer, on which is recorded a computer program comprising computer program code means for implementing the phases and/or stages of a process according to one of Claims 1 to 5.

Initialisation
E1-1 — Imbibition
E1-2 — Mesure
E1

E2 — Phase de charge

Figure 1

Figure 2

```
            ┌─────────────────┐
    E3 ─────│  Imbibition de  │
            │  l'accumulateur │
            └─────────────────┘
                     │
                     ▼
            ┌─────────────────┐
            │     Mesure      │
            │   d'élévation   │───── E4
            └─────────────────┘
                     │
                     ▼
            ┌─────────────────┐
    E5 ─────│    Phase de     │
            │     charge      │
            └─────────────────┘
                     │
                     ▼
            ┌─────────────────┐
            │  Analyse de la  │
            │     charge      │───── E6
            └─────────────────┘
                     │
                     ▼
            ┌─────────────────┐
    E7 ─────│  Génération de  │
            │   l'abaque      │
            └─────────────────┘
```

Figure 3

Figure 4

Figure 5

Figure 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- AU 505599

**Littérature non-brevet citée dans la description**

- **J.E. MANDERS.** Quality-Control techniques for dry charging lead/acid batteries. *Journal of Power Sources,* 01 Février 1987, vol. 19 (2-3), 189-199